Europäisches Patentamt

European Patent Office

Office européen des brevets

(11) Publication number: **0 340 441**

**A2**

## EUROPEAN PATENT APPLICATION

(21) Application number: 89105259.9

(51) Int. Cl.⁴: **H03K 17/94**

(22) Date of filing: 23.03.89

(30) Priority: 06.05.88 JP 59966/88

(43) Date of publication of application:
08.11.89 Bulletin 89/45

(84) Designated Contracting States:
AT BE CH DE ES FR GB IT LI NL SE

(71) Applicant: Schaltbau Gesellschaft mbH
Klausenburger Strasse 6
D-8000 München 80(DE)

(72) Inventor: Ono, Shoichi
No. 21-17 Takashima 1-chome
Suwa-shi Nagano(JP)
Inventor: Kobayashi, Atsuhito
No. 21-17 Takashima 1-chome
Suwa-shi Nagano(JP)

(74) Representative: Patentanwälte Grünecker,
Kinkeldey, Stockmair & Partner
Maximilianstrasse 58
D-8000 München 22(DE)

(54) Photoelectric switch.

(57) In a photoelectric switch for detecting the presence of an object according to whether or not a light from a light projecting part has reached a light receiving part, the improvement comprising:
a voltage controlled oscillator for generating a square wave signal of a frequency proportional to the level of a light reception signal from said light receiving part;
a comparator for deciding whether or not said light reception signal level is on a voltage set at the time of adjustment or over which is higher than a voltage set for normal operation;
a gate circuit for applying a continuous signal generated on decision by the comparator that said light reception signal level is on said voltage set at the time of adjustment or over and the square wave signal generated from said voltage controlled oscillator as a driving signal for indicating light emitting element each.

FIG.1

## PHOTOELECTRIC SWITCH

### Description of the invention

This invention relates to a photoelectric switch having a light projecting part and a light receiving part, which is intended for detection of an object according to a quantity of received light changing from a beam of projected light being intercepted thereby.

The photoelectric switch is that for deciding whether or not an object is present at a position whereat a beam of projected light is intercepted according to whether or not a beam of projected light from a light projecting part is incident on a light receiving part. It is therefore necessary that an optical axis be adjusted so that a beam of projected light from the light projecting part will be incident correctly on the light receiving part. Then, for adjustment of the optical axis, an apparatus for deciding whether or not a beam of projected light is incident correctly on the light receiving part is required at present.

A prior art apparatus of this kind includes that of being disclosed in Japanese Utility Model Publication No. 25185/1978. The apparatus comprises amplifying an electrical signal from a light receiving part which is generated from the light receiving part having received a beam of projected light from a light projecting part, thereby actuating a light emission indicator provided on the light projecting part and light receiving part.

In the aforementioned apparatus, an operation of the light emission indicator is indicative of the beam of projected light having been incident on the light receiving part. However, the light receiving part will detect it and generate an electrical signal despite the optical axis being somewhat displaced, therefore the operation of the light emission indicator itself is still not effective in discriminating whether the optical axis is adjusted to an optimum position or is as displaced somewhat.

Further, another prior art apparatus is exemplified as disclosed in Japanese Utility Model Publication No. 23243/1973. The apparatus is provided with a tuning indicator tube on an amplification output end of an electrical signal generated from the light receiving part on reception of a beam of projected light, namely a light reception signal. Thus, an optical axis is received at the center of light receiving part, and a maximization of the light reception signal can be recognized by a minimization of sector form projected on an indicating part of the tuning indicator tube.

However, it is difficult to discriminate an indication on the tuning indicator tube visually from afar, and particularly in case a distance between the light emitting part and light receiving part is long, an indication on the tuning indicator tube provided at the light receiving part cannot be discriminated at the light emitting part where the optical axis is adjusted, thus involving difficulty in carrying out the adjustment.

A problem inherent in such prior art apparatuses is that it cannot be discriminated whether an optical axis is incident correctly or is displaced to incidence, or it is difficult to discriminate an incident state of the optical axis on the light projecting part side where the adjustment is made practically.

An object of the invention is therefore to provide a photoelectric switch wherein it can definitely be discriminated whether an optical axis is incident in best condition or is somewhat displaced to incidence, and this can be discriminated visually relatively from afar, thus facilitating an adjustment of the optical axis.

The photoelectric switch according to the invention is intended for detection of the presence of an object according to whether or not a light from a light projecting part has reached a light receiving part, comprising a voltage controlled oscillator for generating a square wave of a frequency proportional to a light reception signal level from the light receiving part, and a comparator for deciding whether or not the light reception signal level is on a voltage set at the time of adjustment or over which is higher than a voltage set for normal operation. It further comprises a gate circuit for applying a continuous signal generated by the comparator on decision being the voltage set at the time of adjustment or over and a square wave signal generated from the voltage controlled oscillator as a driving signal for an indicating light emitting element each.

According to the invention, when the light reception signal level is higher than the voltage set at the time of adjustment which is higher than the voltage set for normal operation, the indicating light emitting element is lighted statically on the continuous signal generated from the comparator, indicating that the optical axis is incident in best condition. On the other hand, if the light reception signal level is lower than the voltage set at the time of adjustment, the indicating light emitting element is flickered on the square wave signal of a frequency proportional to the light reception signal level which is generated from the voltage controlled oscillator, indicating that the optical axis is displaced to incidence. Then, the displacement is expressed as a flicker period. That is, the larger the displacement is, the longer the flicker period is, and the flicker period becomes short according as the displacement is small. Accordingly, a working personnel will adjust the optical axis in the direction where a flicker period of the indicating light emitting element gets short.

The invention will now be described with reference to the accompanying drawings representing one embodiment thereof.

Brief Description of the Drawings

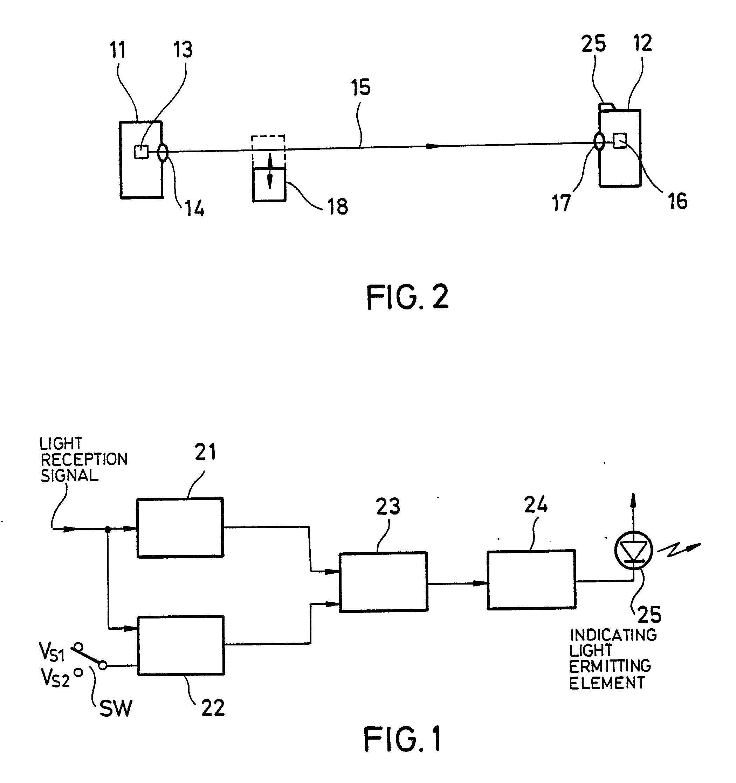

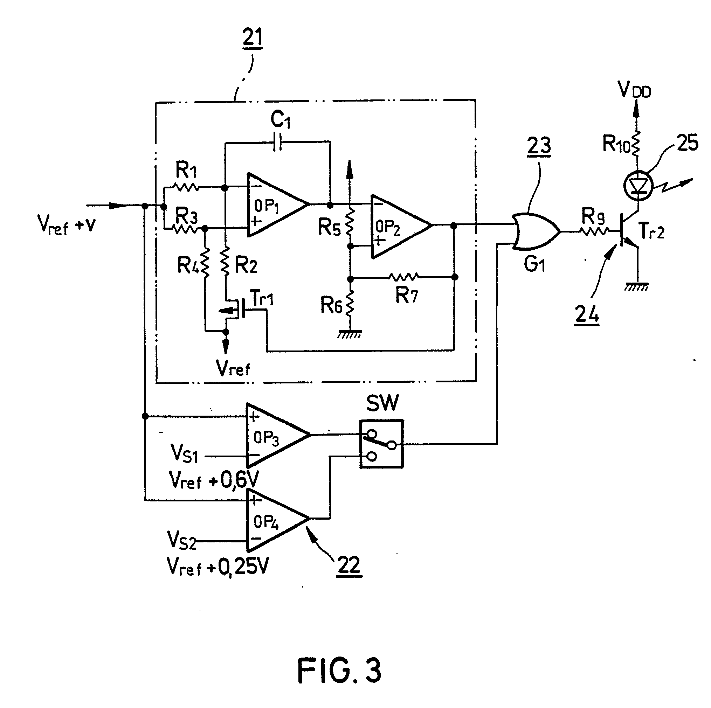

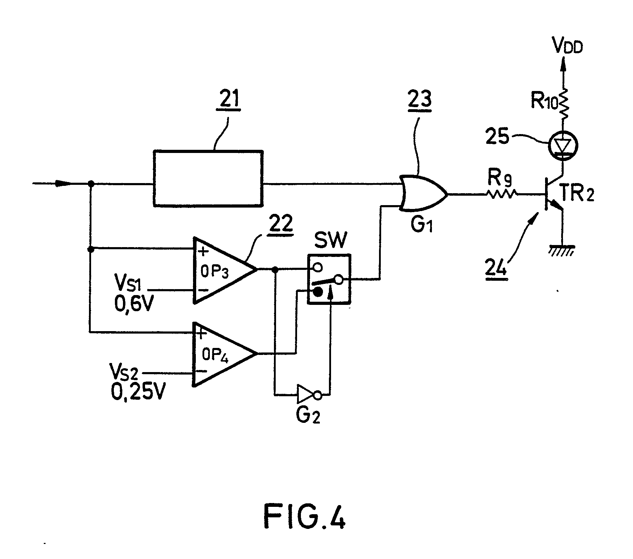

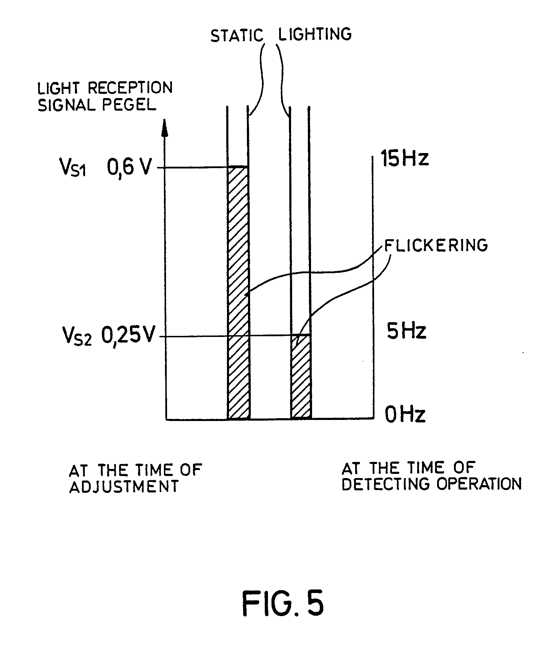

Fig. 1 is a block diagram representing a main part construction of a photoelectric switch given in one embodiment of the invention: Fig. 2 is a conceptional drawing for illustrating a basic construction of a general transmissive photoelectric switch; Fig. 3 is a circuit diagram representing a concrete construction of each part shown in Fig. 1; Fig. 4 is a circuit diagram representing another embodiment of the invention; Fig. 5 is a graph for illustrating an operation of the invention.

A basic construction of a transmissive photoelectric switch is taken up first for description.

A reference numeral 11 denotes a light projecting part, 12 denotes a light receiving part, and the light projecting part 11 has a light emitting element 13 and projects a beam 15 such as infrared ray or the like toward the light receiving part 12 through an emitting lens 14. The light receiving part 12 has a light receiving element 16, receives the beam 15 coming from the light projecting part 11 through a receiving lens 17, and generates an electrical signal in magnitude according to a quantity of received light, namely a light reception signal. A reference numeral 18 denotes an object to be detected, and its presence at a predetermined position is detected by intercepting the beam 15.

Next, a construction of an optical axis incident state detecting part which is a main part of the invention will be described according to Fig. 1.

A reference numeral 21 denotes a voltage controlled oscillator, which inputs the light reception signal and generates a square wave signal of a frequency (0 Hz to 15 Hz, for example) proportional to the light reception signal level.

A reference numeral 22 denotes a comparator, which compares the light reception signal with a set voltage $Vs_1$ or $Vs_2$, and generates a continuous signal of "H" level whenever the light reception signal comes to the set voltage $Vs_1$ or $Vs_2$ or over. Here, $Vs_1$ indicates a voltage set at the time of adjustment, and $Vs_2$ indicates a voltage set for operation when the object is detected. Then, these voltages are set as $Vs_1 > Vs_2$. The set voltages $Vs_1$, $Vs_2$ are selected accordingly on a switch SW.

A reference numeral 23 denotes a gate circuit, which outputs the square wave signal from the voltage controlled oscillator 21 and the continuous signal from the comparator 22 to a drive circuit 24 each, and lights up statically or flickers an indicating light emitting element (LED for example) 25.

A concrete configuration of each circuit described in Fig. 1 will be described with reference to Fig. 3.

With two operational amplifiers $OP_1$, $OP_2$ and a field effect transistor (hereinafter called FET) $Tr_1$ as the main constituents, the voltage controlled oscillator 21 is constructed as illustrated. That is, a light reception signal $Vref + V_1$ (Vref being a reference voltage with $V_1$ as a variation) from the light receiving part 12 is inputted to (-) input end and (+) input end of the operational amplifier $OP_1$ through a resistance $R_1$ or $R_3$. The (-) input end of the operational amplifier $OP_1$ is connected to an output end of same operational amplifier $OP_1$ through a capacitor $C_1$, and is also connected to a supply of the reference voltage Vref through a resistance $R_2$ and source/drain of FET $Tr_1$. Further, (+) input end of same operational amplifier $OP_1$ is connected to the reference voltage Vref supply through a resistance $R_4$.

The operational amplifier $OP_2$ functions as a comparator, and its (-) input end is connected to the output end of the operational amplifier $OP_1$. Then, the (+) input end is connected to a midpoint of resistances $R_5$, $R_6$ and also connected to an output end of same operational amplifier through a resistance $R_7$. The output end of the operational amplifier $OP_2$ is connected to a base of FET $Tr_1$.

An outgoing signal of the voltage controlled oscillator 21 is generated from the output end of the operational amplifier $OP_2$. The outgoing signal is a square wave signal of a frequency proportional to a change (change of $V_1$) of a level of the light reception signal which is an incoming signal, and changes within the range of, for example, 0 Hz to 15 Hz as mentioned hereinbefore. That is, the level of the light reception signal, or the incoming signal $V_1$ will be maximized in best condition where an optical axis of the beam 15 from the light projecting part 11 is incident on the center of the light receiving element 16 of the light receiving part 12, therefore a frequency of the square wave signal is maximized. Then, the level $V_1$ of the light reception signal drops according as the optical axis of the beam 15 is displaced from the center of the light receiving element 16, therefore the frequency of the square wave signal also decreases.

The comparator 22 comprises two comparators $OP_3$, $OP_4$ and a changeover switch SW. The light reception signal $Vref + V_1$ is impressed on each (+) input end of the comparators $OP_3$, $OP_4$. Then, the voltage $Vs_1$ set at the time of adjustment (Vref + 0.6V, for example) is impressed on (-) input end of the one comparator $OP_3$. Further, the voltage

Vs2 set for operation (Vref + 0.25V, for example) is impressed on (-) input end of the other comparator OP4. That is, the comparator OP3 compares $V_1$ with 0.6V for magnitude, while the comparator OP4 compares $V_1$ with 0.25V. Then, when the voltage $V_1$ exceeds 0.6V or 0.25V, each corresponding output is inverted, and the continuous signal of "H" level is generated. Each output of the comparators OP3, OP4 is selected on the changeover switch SW. In this connection, the changeover switch SW in Fig. 1 is indicated to change the set voltages $Vs_1$, $Vs_2$, which is different from that for changing outputs of the comparators OP3, OP4 of Fig. 3 in representation but same in content after all, and hence either will do.

The gate circuit 23 uses an OR gate $G_1$ inputting a square wave signal from the voltage controlled oscillator 21 and a continuous signal from the comparator OP2 or OP4 selected on the switch SW. An output of the OR gate $G_1$ is fed to a base of transistor $Tr_2$ constituting the drive circuit 24 through a resistance $R_9$. The indicating light emitting element (LED for example) 25 and a resistance $R_{10}$ are connected in series to a collector of the transistor $Tr_2$ toward a power source $V_{DD}$. Then, the emitter is connected to ground.

In the aforementioned construction, for adjustment of the optical axis, the higher voltage $Vs_1$ set at the time of adjustment is first selected as the comparator 22. That is, $Vs_1$ is selected on the switch SW in Fig. 1, and the comparator OP3 is selected on the switch SW in Fig. 3.

The beam 15 is projected toward the light receiving part 12 from the light projecting part 11 in such state, however, if an optical axis of the beam 15 is displaced from the center of the light receiving element, the larger the displacement is, the lower the level of light reception signal Vref + $V_1$. The light reception signal Vref + $V_1$ is inputted to the voltage controlled oscillator 21 and the comparator 22. A square wave signal of a frequency proportional to the level (level of $V_1$) of an incoming signal is generated from the voltage controlled oscillator 21. Accordingly, if the optical axis is displaced largely, the square wave signal of low frequency is generated.

Then, in the comparator 22, the comparator OP3 selected on the switch SW compares the incoming signal level $V_1$ with the set voltage $Vs_1$ being 0.6V for magnitude. The set voltage $Vs_1$ is higher in value than the voltage set for operation at the time of normal object detection, and if the optical axis is displaced, then the incoming signal level $V_1$ is not capable of exceeding the set voltage $Vs_1$. Accordingly, the output of the comparator OP3 is kept on "L" level.

Consequently, the OR gate $G_1$, or the gate circuit 23 feeds only the square wave signal from the voltage controlled oscillator 21 to a base of the transistor $Tr_2$ of the drive circuit 24. The transistor $Tr_2$ is turned on every time the square wave signal is impressed on the base, thus actuating the indicating light emitting element 25. The indicating light emitting element 25 thus flickers on a frequency of the square wave signal decided by the voltage controlled oscillator 21.

Here, the set voltage $Vs_1$ (Vref + 0.6V) of the comparator OP3 is sufficiently high in value and is inverted to "H" level from inputting the light reception signal in best condition where the optical axis coincides with the center of the light receiving element 16. In other words, the "L" level is kept on until the best condition is secured. Consequently, the indicating light emitting element 25 keeps flickering until the best condition is obtained, however, the light reception signal level also rises according as the optical axis comes near to the best condition, and a frequency of the square wave signal of the voltage controlled oscillator 21 rises accordingly. That is, a flickering period of the indicating light emitting element 25 becomes short. Accordingly, the working personnel will adjust an optical axis of the beam 15 in the direction where the flickering period becomes short as observing the indicating light emitting element 25 visually. Then, when the optical axis reaches the best condition, the comparator OP3 is inverted to "H" level, and the "H" level output of the OR gate $G_1$ is kept on, therefore the indicating light emitting element 25 is lighted up statically. Accordingly, the optical axis will be fixed finally in the state where the indicating light emitting element 25 has been lighted up statically, thus closing the adjusting work.

After adjustment the switch SW is changed to drop the set voltage as the comparator 22 to $Vs_1$ - (Vref + 0.25V). From operating such, the indicating light emitting element 25 will never flicker until the incoming signal $V_1$ becomes less than 0.25V. That is, a tolerance of 0.35V (0.6V - 0.25V = 0.35V) will be left after adjustment. Consequently, if the optical axis is somewhat displaced for some reason or other after adjustment to the best condition, a normal operation for detecting the object can be maintained.

Fig. 5 illustrates a relation between the aforementioned incoming signal (light reception signal) and the set voltages $Vs_1$, $Vs_2$ of the comparator 22, a relation between a static lighting and flickering of the indicating light emitting element, and further a flicker frequency collectively.

As described a desired value for the best condition wherein the indicating light emitting element 25 is lighted statically is taken high at the time of adjustment, and the desired value is brought down somewhat at the time of detecting operation on the other hand, and thus an accurate adjustment of the optical axis is further ensured, and the system is capable of coping powerfully with a change in the environment such as oil stain, mist and the like in addition to a displacement of the optical axis.

Then, a mode for indicating a displacement of the optical axis is realized on the indicating light emitting element 25 in flickering which is effective in stimulating the human eyesight to observe relatively from afar, therefore the situation can be discriminated easily by far as compared with that of being hard to observe like a prior art tuning indicator tube or of changing a color of the light emitting element analogically as red → yellow → green, and the optical axis can easily be adjusted on a side of the light projecting part 11.

Further, S/N ratio will be enhanced by applying hysteresis to the comparators $OP_3$, $OP_4$.

In the above-described embodiment, the set voltages $Vs_1$, $Vs_2$ in the comparator 22 are changed by operating the switch SW manually, however, the system may comprise otherwise being in an adjusted state ($Vs_1$ being selected) at the time of power closing (initialized), selecting the voltage $Vs_2$ set for operation automatically after adjustment. The embodiment will be described hereunder with reference to Fig. 4. Like reference characters then represent like parts in Fig. 3, and hence a further description is omitted thereof.

In the embodiment of Fig. 4, that of being controlled on an invertor $G_2$ with the output of the comparator $OP_3$ as input is used as the changeover switch SW. That is, the output of the comparator $OP_3$ is on the "L" level at the time of adjustment unless the optical axis is optimized. The "L" level output is turned to "H" level by the invertor $G_2$, and the switch SW is changed to a side of the comparator $OP_3$. Then, when the optical axis is optimized (adjustment being over), the output of the comparator $OP_3$ becomes "H" level. The "H" level output is turned to "L" level by the invertor $G_2$, and the switch SW is reset to a side of the comparator $OP_4$.

Accordingly, a set voltage of the comparator 22 at the time of normal object detection becomes $Vs_2$, and a normal operation can be kept on until the incoming signal level $V_1$ becomes 0.25V or below. Then, when $V_1$ becomes less than 0.25V for some reason or other, the indicating light emitting element 25 recommences flickering, the switch SW is changed over to the comparator $OP_3$, and the flickering goes on until $V_1$ becomes greater than 0.6V.

As described above, according to the invention, whether or not a beam of light is incident correctly on the light receiving part can definitely be discriminated by static lighting and flickering of the indicating light emitting element, and a displacement of the optical axis can also be discriminated by discrepancy of the flickering period, therefore the operation for adjusting the optical axis can be facilitated as compared with a prior art, and the optical axis can be optimized at high precision.

**Claims**

(1) In a photoelectric switch for detecting the presence of an object according to whether or not a light from a light projecting part has reached a light receiving part, the improvement comprising:
a voltage controlled oscillator for generating a square wave signal of a frequency proportional to the level of a light reception signal from said light receiving part;
a comparator for deciding whether or not said light reception signal level is on a voltage set at the time of adjustment or over which is higher than a voltage set for normal operation;
a gate circuit for applying a continuous signal generated on decision by the comparator that said light reception signal level is on said voltage set at the time of adjustment or over and the square wave signal generated from said voltage controlled oscillator as a driving signal for indicating light emitting element each.

FIG. 2

LIGHT
RECEPTION
SIGNAL

$V_{S1}$
$V_{S2}$
SW

INDICATING
LIGHT
EMITTING
ELEMENT

FIG. 1

FIG. 3

FIG.4

FIG. 5